Europäisches Patentamt

European Patent Office

Office européen des brevets

(19)

(11) Numéro de publication : **0 632 585 A1**

# (12) DEMANDE DE BREVET EUROPEEN

(21) Numéro de dépôt : **94401444.8**

(22) Date de dépôt : **27.06.94**

(51) Int. Cl.⁶ : **H03G 3/20**

(30) Priorité : **30.06.93 FR 9307998**

(43) Date de publication de la demande :
**04.01.95 Bulletin 95/01**

(84) Etats contractants désignés :
**DE ES FR GB IT NL SE**

(71) Demandeur : **ALCATEL TELSPACE**
**5, rue Noel Pons**
**F-92734 Nanterre Cédex (FR)**

(72) Inventeur : **Raynaud, Fabrice**
**20, Rue Parmentier**
**F-92000 Nanterre (FR)**
Inventeur : **Regnier, Patrice**
**21, Rue Victor Hugo**
**F-92400 Courbevoie (FR)**

(74) Mandataire : **Pothet, Jean Rémy Emile Ludovic**
**et al**
**c/o SOSPI**
**14-16 rue de la Baume**
**F-75008 Paris (FR)**

(54) **Système de commande de la polarisation d'un amplificateur.**

(57) Le système comporte des moyens de prélèvement (11) d'une fraction du signal d'entrée (Ve)
de l'amplificateur (10), des moyens d'atténuation (12) du signal prélevé, des moyens de
détection (15) du signal atténué, des moyens de
comparaison (16) de la tension détectée (Vd)
avec une tension de référence (Vref) qui fournissent un niveau logique, des moyens de
commande (17) recevant ce niveau logique et
générant un signal de commande (S) appliqué
aux moyens d'atténuation (12) pour que la tension détectée (Vd) soit sensiblement égale à la
tension de référence (Vref) et des moyens de
génération (18) du signal de polarisation (Vp)
recevant le signal de commande (S) des moyens
de commande (17), ces différents moyens coopérant entre eux de telle sorte que la polarisation de l'amplificateur (10) soit la plus faible
possible tout en assurant une amplification
sans écrétage du signal d'entrée (Ve).

FIG.1

Le domaine de l'invention est celui des systèmes de commande de la polarisation d'amplificateurs. L'invention s'applique notamment aux amplificateurs hyperfréquence de puissance à grande dynamique de puissance de sortie utilisés dans les émetteurs ou récepteurs de signaux transmis en mode AMRT (Accès Multiple à Répartition dans le Temps).

La présente invention se propose d'optimiser le rendement d'un amplificateur utilisé en émission ou en réception de signaux radioélectriques, par exemple transmis en mode AMRT. Elle permet d'assurer un gain d'amplification constant en polarisant l'amplificateur de telle sorte que le signal qui lui est appliqué soit amplifié linéairement, avec une consommation minimale, c'est à dire avec une polarisation minimale. L'invention s'applique notamment à tous les types de signaux transmis en mode AMRT, quelle que soit la longueur des paquets reçus, leur amplitude, leur dynamique et leur espacement temporel.

La demande de brevet européen n°0.472.330 au nom de MATSUSHITA ELECTRIC INDUSTRIAL CO., LTD décrit un système d'amplification d'un signal hyperfréquence transmis en mode AMRT où un détecteur à diode détecte l'amplitude du signal de sortie d'un amplificateur. Ce détecteur coopère avec un atténuateur numérique recevant l'enveloppe du signal amplifié pour augmenter la sensibilité du détecteur placé en aval qui est en principe limitée à environ 20 dB. Ainsi, l'atténuateur subit une loi de commande préalablement établie dépendant de l'enveloppe du signal à amplifier.

Le principal inconvénient de ce type de système est qu'il nécessite un circuit, par exemple une mémoire EEPROM, qui génère l'enveloppe du signal à amplifier. La programmation de cette EEPROM suppose de connaître la longueur des paquets reçus et leur position relative dans le temps. De plus, il est nécessaire d'utiliser un linéariseur dans la chaîne de commande de l'amplificateur pour compenser la caractéristique non linéaire de la diode de détection.

Pour remédier à ces inconvénients, l'invention propose un système de commande de la polarisation d'un amplificateur recevant un signal d'entrée et un signal de polarisation, l'amplificateur fournissant un signal de sortie amplifié, ce système comportant :
- des moyens de prélèvement d'une fraction du signal d'entrée ou du signal de sortie, les moyens de prélèvement fournissant un signal prélevé ;
- des moyens d'atténuation du signal prélevé fournissant un signal atténué ;
- des moyens de détection du signal atténué fournissant une tension détectée ;
- des moyens de comparaison de la tension détectée avec une tension de référence, les moyens de comparaison fournissant un niveau logique ;
- des moyens de commande recevant le niveau logique et générant un signal de commande appliqué aux moyens d'atténuation pour que la tension détectée soit sensiblement égale à la tension de référence ;
- des moyens de génération du signal de polarisation recevant le signal de commande des moyens de commande,
ces moyens coopérant entre eux de telle sorte que le gain de l'amplificateur soit constant et dans la plage linéaire d'amplification et que la polarisation de cet amplificateur soit la plus faible possible tout en assurant une amplification sans écrétage du signal d'entrée.

Avantageusement, les moyens de commande sont constitués par un compteur-décompteur générant des mots binaires et les moyens de génération du signal de polarisation comprennent un convertisseur numérique-analogique recevant les mots binaires de ce compteur-décompteur pour fournir un signal analogique à un filtre passe-bas dont le signal de sortie constitue le signal de commande de polarisation.

Préférentiellement, les moyens d'atténuation sont constitués par un jeu de plusieurs atténuateurs commandés numériquement et reliés en cascade, ces atténuateurs coopérant avec un décodeur recevant les mots binaires.

L'amplificateur dont on commande la polarisation comporte avantageusement au moins un transistor hyperfréquence.

Dans un mode de réalisation avantageux, le système de l'invention comporte :
- des moyens de prélèvement d'une fraction du signal d'entrée fournissant un premier signal prélevé ;
- des moyens de prélèvement d'une fraction du signal de sortie fournissant un second signal prélevé ;
- des moyens d'atténuation du premier signal prélevé fournissant un premier signal atténué ;
- des moyens d'atténuation du second signal prélevé fournissant un second signal atténué ;
- des moyens de détection du premier signal atténué fournissant une première tension détectée ;
- des moyens de détection du second signal atténué fournissant une seconde tension détectée ;
- des moyens de comparaison de la première tension détectée avec une première tension de référence, les moyens de comparaison fournissant un premier niveau logique ;
- des moyens de comparaison de la seconde tension détectée avec une seconde tension de référence, les moyens de comparaison fournissant un second niveau logique ;
- des moyens de commande recevant le premier niveau logique et générant un premier signal de commande appliqué aux moyens d'atténuation du premier signal prélevé pour que la première tension détectée soit sensiblement égale à la première tension de référence ;

- des moyens de commande recevant le second niveau logique et générant un second signal de commande appliqué aux moyens d'atténuation du second signal prélevé pour que la seconde tension détectée soit sensiblement égale à la seconde tension de référence ;
- des moyens de soustraction soustrayant le premier signal de commande du second signal de commande pour obtenir un signal différence ;
- des moyens de génération du signal de polarisation recevant le signal différence et fournissant au amplificateur une tension Vco égale à :

$$Vco = Vpo + \mu.Va_1 - h.(Va_2 - Va_1)$$

où Vpo est une tension d'offset, $\mu$ et h sont des constantes, $Va_1$ et $Va_2$ sont respectivement les premier et second signaux de commande.

On assure ainsi une correction des évolutions des caractéristiques de l'amplificateur.

Préférentiellement, chacun des moyens de détection est constitué par une diode de détection de tension et chacune des première et seconde tensions de référence est égale à :

$$Vr - k.V.(To - T)$$

où Vr est une tension fixe, k est une constante positive de température d'une diode de détection de température placée à proximité de la diode de détection de tension correspondante, V est la tension fournie par la diode de détection de température, To est une température de référence et T est la température ambiante.

On compense ainsi également les variations de température ambiante.

D'autres caractéristiques et avantages de l'invention apparaîtront à la lecture de la description suivante d'un mode de réalisation préférentiel, donné à titre illustratif et non limitatif, et des dessins annexés dans lesquels :

- la figure 1 est un schéma synoptique d'un mode de réalisation préférentiel de l'invention ;
- la figure 2 qui représente une droite de charge statique d'un transistor constituant l'amplificateur de la figure 1 ;
- la figure 3 est un schéma synoptique d'un mode de réalisation de l'invention permettant de tenir compte des évolutions des paramètres de fonctionnement de l'amplificateur et des évolutions de température.

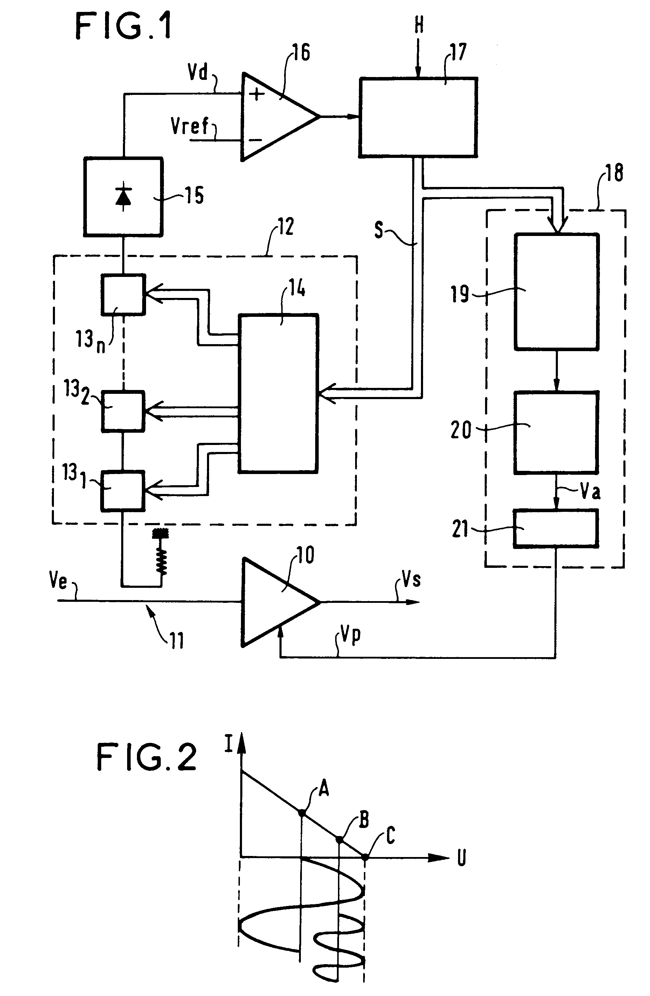

La figure 1 est un schéma synoptique d'un mode de réalisation préférentiel de l'invention.

Un amplificateur 10 dont on veut optimiser le rendement reçoit un signal d'entrée hyperfréquence Ve à amplifier et fournit un signal amplifié Vs. L'amplificateur 10 reçoit également un signal de polarisation Vp sur une entrée de commande. Des moyens 11, par exemple constitués par un coupleur directif, prélèvent une fraction du signal d'entrée Ve et fournissent un signal prélevé à des moyens d'atténuation 12 de ce signal prélevé. Les moyens d'atténuation 12 sont ici constitués de n atténuateurs numériques $13_1$, $13_2$,..., $13_n$ en cascade pilotés par un décodeur 14. Les moyens d'atténuation 12 fournissent un signal atténué à des moyens de détection 15 constitués par un détecteur à diode. Ce détecteur fournit une tension détectée Vd à des moyens de comparaison 16 qui comparent cette tension détectée Vd à une tension de référence Vref.

Les moyens de comparaison 16 sont par exemple constitués par un simple amplificateur opérationnel à hystérésis. Cet amplificateur fournit sur sa sortie un niveau logique (0 ou 1) à des moyens de commande 17 qui génèrent un signal de commande S appliqué aux moyens d'atténuation 12 pour que la tension détectée Vd soit sensiblement égale à la tension de référence Vref. On obtient ainsi une boucle qui commande les moyens d'atténuation 12 pour que la tension détectée Vd soit égale à Vref. Le signal de commande S a une valeur qui augmente dans le temps lorsque l'amplificateur opérationnel 16 sort un niveau logique 1 et, réciproquement, une valeur qui diminue dans le temps lorsque l'amplificateur opérationnel 16 sort un niveau logique 0.

Il est à noter que les moyens de prélèvement 11 peuvent également prélever une fraction du signal de sortie Vs de l'amplificateur 10, ce montage constituant alors une boucle de contre-réaction, alors que le système représenté à la figure 1 est de type "feed forward".

De façon à protéger le détecteur 15, les atténuateurs sont positionnés à l'initialisation du système à leur valeur maximale. Ainsi, tant que la tension Vd sera inférieure à Vref, un niveau logique bas sera présent à l'entrée des moyens de commande 17 et ceux-ci vont générer un nombre binaire sans cesse décroissant jusqu'à ce que Vd soit supérieur à Vref.

Le nombre binaire est codé sur un nombre de bits qui est fonction du nombre d'atténuateurs. A titre d'exemple, l'utilisation de 3 atténuateurs numériques commandés sur 4 bits permet d'obtenir une dynamique de 60 dB pour des fréquences allant du continu à 2 GHz.

Bien entendu, les moyens de commande 17 peuvent également être de type analogique et par exemple constitués par un intégrateur fournissant une tension dont la variation commande des moyens d'atténuation analogiques pour que Vd soit égal à Vref. Le système de commande des atténuateurs est cependant plus complexe puisqu'ils doivent être utilisés dans leur zone linéaire. Les moyens de comparaison 16 présentent de préférence un hystérésis pour éviter des transitions de sortie trop fréquentes.

La tension Vref est fonction des caractéristiques du détecteur à diode 15 et correspond à une tension pour laquelle la caractéristique I = f(U) de ce détecteur présente une pente minimale de part et d'autre de ce point de fonctionnement, c'est à dire à un point où la sensibilité du détecteur est la plus importante.

Les moyens de commande sont ici de type numérique et fournissent donc des mots binaires à la fréquence d'une horloge de commande H. Ils peuvent être constitués par un compteur-décompteur dont le mot binaire de sortie a un poids qui augmente ou diminue à chaque coup d'horloge H, en fonction du résultat de la comparaison de Vd et Vref.

Le signal de commande S est également appliqué à des moyens 18 de génération du signal de polarisation appliqué à l'amplificateur 10. Ces moyens comprennent dans la figure 1 un convertisseur numérique-analogique 19 suivi d'un filtre passe-bas 20 fournissant une tension Va. Un convertisseur de tension 21 fournit la tension de polarisation Vp à l'amplificateur 10. Ce convertisseur 21 transforme par exemple Va en Vp = a.Va + b où a et b sont des constantes et assure ainsi que l'amplificateur 10 est polarisé avec un courant suffisant pour réaliser une amplification de Ve sans écrétage et à courant de polarisation minimum. Le gain de l'amplificateur 10 est alors sensiblement constant, dans la plage linéaire d'amplification et sa polarisation en courant est adaptée à la puissance du signal appliqué à son entrée.

Le fonctionnement du dispositif de l'invention sera mieux compris à la description suivante de la figure 2 qui représente une droite de charge statique d'un transistor constituant l'amplificateur 10.

Trois points de fonctionnement A, B et C sont ici représentés. Le point de fonctionnement A correspond à un fonctionnement en classe A : la polarisation de l'amplificateur est maximale pour que le signal d'amplitude importante appliqué à l'entrée de l'amplificateur soit amplifié sans saturation. Au contraire, pour un signal de plus faible amplitude, on obtient une amplification sans écrétage en plaçant le point de fonctionnement au point B, c'est à dire en diminuant le courant de polarisation de l'amplificateur. On adapte ainsi la polarisation de l'amplificateur en fonction de l'amplitude du signal d'entrée et il en résulte un rendement optimal. On notera que le point de fonctionnement C correspond à une absence d'un signal à amplifier. L'amplificateur est alors au repos et ne consomme aucun courant.

La présente invention s'applique préférentiellement aux amplificateurs constitués par des transistors MOSFET de puissance fonctionnant aux hyperfréquences. Plusieurs transistors de ce type peuvent être montés en cascade.

Le système décrit en référence à la figure 1 peut encore être amélioré pour tenir compte des dérives des caractéristiques de l'amplificateur 10. Il est en effet nécessaire de s'affranchir de ces dérives si l'on désire conserver une amplification linéaire et donc placer un second détecteur en sortie de cet amplificateur. Il est également souhaitable de compenser les dérives thermiques qui déplacent le point de fonctionnement du détecteur 15.

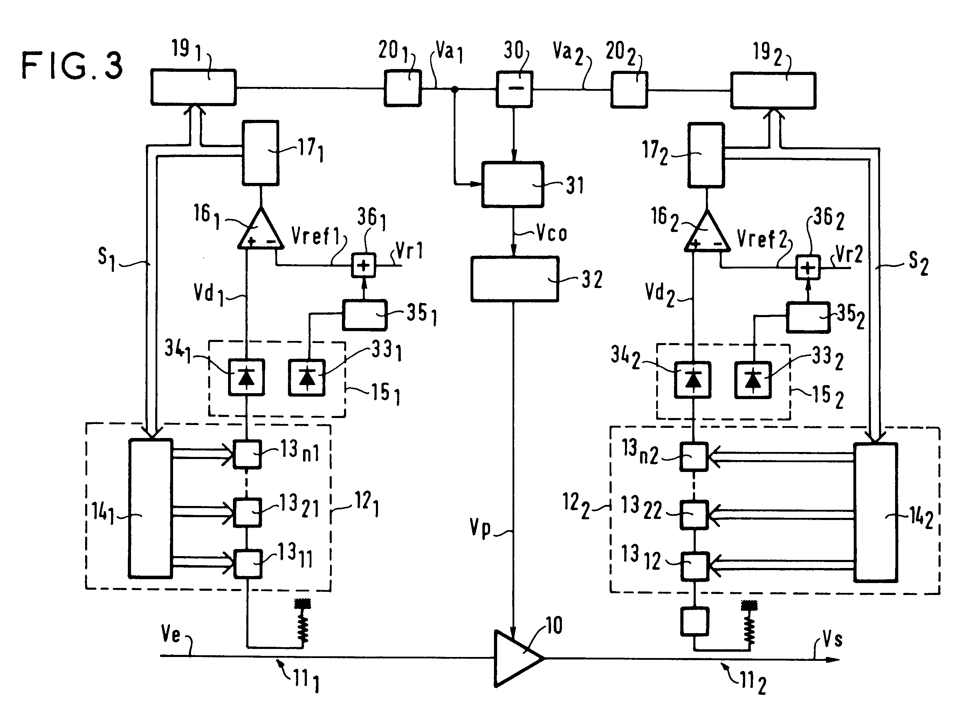

La figure 3 est un schéma synoptique d'un mode de réalisation de l'invention permettant de tenir compte des évolutions de température et des paramètres de fonctionnement de l'amplificateur.

Le système représenté comporte des éléments identiques à ceux décrits en référence à la figure 1 où le détecteur recevait une fraction du signal d'entrée (ou de sortie) atténué et comporte des éléments identiques traitant le signal de sortie de cet amplificateur. Il comporte :

- des moyens $11_1$ de prélèvement d'une fraction du signal d'entrée Ve fournissant un premier signal prélevé ;
- des moyens de prélèvement $11_2$ d'une fraction du signal de sortie fournissant un second signal prélevé ;
- des moyens d'atténuation $12_1$ du premier signal prélevé fournissant un premier signal atténué ;
- des moyens d'atténuation $12_2$ du second signal prélevé fournissant un second signal atténué ;
- des moyens $15_1$ de détection du premier signal atténué fournissant une première tension détectée $Vd_1$ ;
- des moyens de détection du second signal atténué fournissant une seconde tension détectée $Vd_2$ ;
- des moyens de comparaison $16_1$ de la première tension détectée $Vd_1$ avec une première tension de référence $Vref_1$, ces moyens de comparaison $16_1$ fournissant un premier niveau logique ;
- des moyens de comparaison $16_2$ de la seconde tension détectée $Vd_2$ avec une seconde tension de référence $Vref_2$, ces moyens de comparaison $16_2$ fournissant un second niveau logique ;
- des moyens de commande $17_1$ recevant le premier niveau logique et générant un premier signal de commande $S_1$ appliqué aux moyens d'atténuation $12_1$ du premier signal prélevé pour que la première tension détectée $Vd_1$ soit sensiblement égale à la première tension de référence $Vref_1$ ;
- des moyens de commande $17_2$ recevant le second niveau logique et générant un second signal de commande S2 appliqué aux moyens d'atténuation $12_2$ du second signal prélevé pour que la seconde tension détectée $Vd_2$ soit sensiblement égale à la seconde tension de référence $Vref_2$ ;
- des moyens de soustraction 30 soustrayant le premier signal de commande S1 du second signal de commande S2 pour obtenir un signal différence S2-S1 ; ces moyens de soustraction opèrent ici par l'intermédiaire de convertisseurs numériques-analogiques $19_1$ et $19_2$ suivis de filtres passe-bas $20_1$ et $20_2$ et $S_2\text{-}S_1$ correspond à $Va_2\text{-}Va_1$ ;
- des moyens 31 de génération du signal de polarisation recevant le signal différence $Va_2\text{-}Va_1$ et fournissant à l'amplificateur 10 une tension Vco égale à :

$$Vco = Vpo + \mu.Va_1 - h.(Va_2 - Va_1)$$

où Vpo est une tension d'offset, $\mu$ et h sont des constantes, $Va_1$ et $Va_2$ sont respectivement les premier et second signaux de commande.

Un dispositif 32 à transistors peut être rajouté pour adapter la tension Vco à l'amplificateur 10 en réalisant Vp = a.Vco + b où a et b sont des constantes. On assure ainsi la présence d'un courant de polarisation adapté à l'amplificateur utilisé.

Ainsi, la tension Vco va suivre l'évolution de la tension d'entrée Ve, mais va également être modulée par la valeur du gain de l'amplificateur. On tient ainsi compte des dérives des caractéristiques de cet amplificateur. Ainsi, l'amplificateur fonctionne dans sa plage de gain linéaire souhaitée et le courant de polarisation est optimal, c'est à dire le plus faible possible sans entraîner d'écrétage du signal amplifié.

La compensation en température de chaque détecteur peut être obtenue à l'aide de diodes de détection de température, identiques aux diodes de détection de tension utilisées pour les obtentions de $Vd_1$ et $Vd_2$ et placées à proximité de celles-ci pour qu'elles subissent les mêmes dérives thermiques. Ces diodes de détection de température sont référencées $33_1$ et $33_2$, alors que les diodes de détection de tension fournissant $Vd_1$ et $Vd_2$ sont référencées $34_1$ et $34_2$. Les tensions de sortie des diodes de détection de température $33_1$ et $33_2$ sont appliquées à des modules $35_1$ et $35_2$ fournissant chacun une tension de sortie égale à :

$$- k.V.(To - T)$$

où k est la constante de température de la diode de détection de température utilisée (k>0), V est la tension fournie par cette diode, To une température de référence (par exemple 25°C) et T la température ambiante.

Les tensions de sortie de ces modules sont appliquées à des sommateurs $36_1$ et $36_2$ recevant par ailleurs des tensions fixes $Vr_1$ et $Vr_2$. Les sommateurs fournissent sur leurs sorties les tensions de référence $Vref_1$ et $Vref_2$. On réalise ainsi une compensation des variations de la température ambiante qui entraînent un déplacement du point de fonctionnement des diodes de détection de tension $34_1$ et $34_2$.

Les moyens de prélèvement $11_2$ d'une fraction du signal de sortie de l'amplificateur comprennent préférentiellement un atténuateur fixe 37 dont l'atténuation est telle que le niveau du signal de sortie qu'il fournit est égal à celui issu des moyens de prélèvement $11_1$. Les dispositifs situés en amont et en aval de l'amplificateur 10 peuvent alors être identiques puisqu'ils fonctionnent avec des puissances d'entrée comparables.

La présente invention permet d'optimiser la polarisation d'un amplificateur sur une très grande dynamique tout en restant indépendant de l'enveloppe du signal d'entrée. La puissance dissipée par l'amplificateur est diminuée et on assure ainsi une plus grande autonomie aux émetteurs et/ou récepteurs de signaux radioélectriques fonctionnant sur piles ou batteries.

## Revendications

1. Système de commande de la polarisation d'un amplificateur (10) recevant un signal d'entrée (Ve) et un signal de polarisation (Vp), ledit amplificateur (10) fournissant un signal de sortie amplifié (Vs), caractérisé en ce qu'il comporte :
   - des moyens de prélèvement (11) d'une fraction dudit signal d'entrée (Ve) ou dudit signal de sortie (Vs), lesdits moyens de prélèvement (11) fournissant un signal prélevé ;
   - des moyens d'atténuation (12) dudit signal prélevé fournissant un signal atténué ;
   - des moyens de détection (15) dudit signal atténué fournissant une tension détectée (Vd);
   - des moyens de comparaison (16) de ladite tension détectée (Vd) avec une tension de référence (Vref), lesdits moyens de comparaison (16) fournissant un niveau logique ;
   - des moyens de commande (17) recevant ledit niveau logique et générant un signal de commande (S) appliqué auxdits moyens d'atténuation (12) pour que ladite tension détectée (Vd) soit sensiblement égale à ladite tension de référence (Vref) ;
   - des moyens de génération (18) dudit signal de polarisation (Vp) recevant ledit signal de commande (S) desdits moyens de commande (17),
   
   ces moyens coopérant entre eux de telle sorte que le gain dudit amplificateur (10) soit constant et dans la plage linéaire d'amplification et que la polarisation dudit amplificateur (10) soit la plus faible possible tout en assurant une amplification sans écrétage dudit signal d'entrée (Ve).

2. Système selon la revendication 1, caractérisé en ce que lesdits moyens de commande (17) sont constitués par un compteur-décompteur générant des mots binaires.

3. Système selon l'une des revendications 1 et 2, caractérisé en ce que lesdits moyens de génération (18) dudit signal de polarisation (Vp) comprennent un convertisseur numérique-analogique (19) recevant lesdits mots binaires dudit compteur-décompteur (17) et fournissant un signal analogique à un filtre passe-bas (20) dont le signal de sortie constitue ledit signal de polarisation.

4. Système selon l'une des revendications 1 à 3, caractérisé en ce que lesdits moyens d'atténuation (12) sont constitués par un jeu de plusieurs atté-nuateurs ($13_1$ à $13_n$) commandés numériquement et reliés en cascade, lesdits atténuateurs ($13_1$ à $13_n$) coopérant avec un décodeur (14) recevant lesdits mots binaires.

5. Système selon l'une des revendications 1 à 4, caractérisé en ce que ledit amplificateur (10) comporte au moins un transistor hyperfréquence.

6. Système de commande de la polarisation d'un amplificateur (10) recevant un signal d'entrée (Ve) et un signal de polarisation (Vp), ledit amplificateur (10) fournissant un signal de sortie (Vs) amplifié, caractérisé en ce qu'il comporte :
    - des moyens de prélèvement ($11_1$) d'une fraction dudit signal d'entrée (Ve) fournissant un premier signal prélevé ;
    - des moyens de prélèvement ($11_2$) d'une fraction dudit signal de sortie (Vs) fournissant un second signal prélevé ;
    - des moyens d'atténuation ($12_1$) dudit pre-mier signal prélevé fournissant un premier signal atténué ;
    - des moyens d'atténuation ($12_2$) dudit se-cond signal prélevé fournissant un second signal atténué ;
    - des moyens de détection ($15_1$) dudit pre-mier signal atténué fournissant une premiè-re tension détectée ($Vd_1$) ;
    - des moyens de détection ($15_2$) dudit second signal atténué fournissant une seconde tension détectée ($Vd_2$) ;
    - des moyens de comparaison ($16_1$) de ladite première tension détectée ($Vd_1$) avec une première tension de référence ($Vref_1$), les-dits moyens de comparaison ($16_1$) fournis-sant un premier niveau logique ;
    - des moyens de comparaison ($16_2$) de ladite seconde tension détectée ($Vd_2$) avec une seconde tension de référence ($Vref_2$) , les-dits moyens de comparaison ($16_2$) fournis-sant un second niveau logique ;
    - des moyens de commande ($17_1$) recevant ledit premier niveau logique et générant un premier signal de commande ($S_1$) appliqué auxdits moyens d'atténuation ($12_1$) dudit premier signal prélevé pour que ladite pre-mière tension détectée ($Vd_1$) soit sensible-ment égale à ladite première tension de ré-férence ($Vref_1$) ;
    - des moyens de commande ($17_2$) recevant ledit second niveau logique et générant un second signal de commande ($S_2$) appliqué auxdits moyens d'atténuation ($12_2$) dudit second signal prélevé pour que ladite se-conde tension détectée ($Vd_2$) soit sensible-ment égale à ladite seconde tension de ré-férence ($Vref_2$) ;
    - des moyens de soustraction (30) soustrayant ledit premier signal de commande ($Va_1$) dudit second signal de commande ($Va_2$) pour obtenir un signal différence ($Va_2$-$Va_1$) ;
    - des moyens de génération (31) dudit signal de polarisation (Vco) recevant ledit signal différence ($Va_2$-$Va_1$) et fournissant audit amplificateur (10) une tension Vco égale à :
    $$Vco = Vpo + \mu.Va_1 - h.(Va_2 - Va_1)$$
    où Vpo est une tension d'offset, $\mu$ et h sont des constantes, $Va_1$ et $Va_2$ sont respectivement les-dits premier et second signaux de commande.

7. Système selon la revendication 6, caractérisé en ce que chacun desdits moyens de détection ($15_1$, $15_2$) est constitué par une diode de détection de tension ($34_1$, $34_2$) et en ce que chacune desdites première et seconde tensions de référence ($Vref_1$, $Vref_2$) est égale à :
    $$Vr - k.V.(To - T)$$
où Vr est une tension fixe, k est une constante positive de température d'une diode de détection de température ($33_1$, $33_2$) placée à proximité de la diode de détection de tension ($34_1$, $34_2$) corres-pondante, V est la tension fournie par ladite diode de détection de température ($33_1$, $33_2$), To est une température de référence et T est la tempé-rature ambiante.

FIG.1

FIG.2

FIG. 3

**Office européen des brevets**

# RAPPORT DE RECHERCHE EUROPEENNE

Numero de la demande

EP 94 40 1444

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| X | US-A-5 204 637 (L. TRINH) <br> * colonne 3, ligne 19 - ligne 49; figure 2 * <br> --- | 1,4,5 | H03G3/20 |
| Y | EP-A-0 509 733 (MITSUBISHI DENKI KABUSHIKI KAISHA) <br> * le document en entier * <br> --- | 1,2,4,5 | |
| Y | EP-A-0 523 718 (NEC CORPORATION) <br> * le document en entier * <br> --- | 1,2,4,5 | |
| A | WO-A-92 05631 (TELENOKIA OY) <br> * abrégé * <br> ----- | 6 | |

| | | | DOMAINES TECHNIQUES RECHERCHES (Int.Cl.6) |
|---|---|---|---|
| | | | H03G |

Le présent rapport a été établi pour toutes les revendications

| Lieu de la recherche | Date d'achèvement de la recherche | Examinateur |
|---|---|---|
| LA HAYE | 7 Octobre 1994 | Blaas, D-L |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)